# EUROPEAN PATENT APPLICATION

(11) **EP 3 961 834 A1**
(43) Date of publication of application: **02.03.2022**
(21) Application number: 20192859.5
(22) Date of filing: 26.08.2020
(51) Int. Cl.: H02G 5/10, H02B 1/56

(54) **COOLING SYSTEM FOR A MEDIUM VOLTAGE SWITCHGEAR**

(71) Applicant: ABB Schweiz AG, 5400 Baden (CH)
(72) Inventor: KESSLER, Michael, 42579 Heiligenhaus (DE); STADNICKI, Adrian, 40883 Ratingen (DE); SOLOGUBENKO, Oleksandr, 8906 Bonstetten (CH); RYBAK, Andrzej, 30-732 Kraków (PL); ZITZMANN, Robby, 40822 Mettmann (DE)
(74) Representative: Maiwald Patent- und Rechtsanwaltsgesellschaft mbH

(57) **Abstract**

The invention relates to a cooling system for a medium voltage switchgear, the cooling system comprising:
- a conductor;
- a fluid conduit; and
- an insulator;
wherein, the conductor extends in a longitudinal axis; wherein, the conductor is configured to carry electrical current in the longitudinal axis direction;
wherein, a first part of the fluid conduit is located around an outer surface of the conductor and extends around the longitudinal axis;
wherein, a second part of the fluid conduit is connected to the first part of the fluid conduit and extends substantially perpendicularly to the longitudinal axis;
wherein, the insulator is located around the conductor at the position of the fluid conduit and covers the first part of the fluid conduit; and
wherein, the cooling system is configured such that a fluid can flow into the second part of the fluid conduit and from the second part of the fluid conduit into the first part of the fluid conduit.

## Description

### FIELD OF THE INVENTION

The present invention relates to a cooling system for a medium voltage switchgear, a cooling structure for a medium voltage switchgear, a method of manufacturing a cooling system for a medium voltage switchgear, and a medium voltage switchgear.

### BACKGROUND OF THE INVENTION

Medium voltage (MV) air and gas insulated switchgear, also called panels, require cooling.

For high nominal currents in conductors in such switchgears Joule heating occurs due to current flow in the conductors, and heat dissipation is always a challenge.

Usually cooling measures are taken to improve convective cooling such as using heat sinks or large gas coolers. Alternatively, measures to improve heat radiation are also utilized, such as using paintings on surfaces.

Heat pipe solutions are also available, which can lead the heat to a cold end in a very efficient way. Usually such heat pipes consist of metallic tubes to provide an excellent tightness for the cooling fluids over the required lifetime. But the operational voltages in medium voltage switchgears are actually very high, and it is necessary to split such metallic heat pipes between the part directly connected to a thermal hot spot at high potential and a cold part that can be at ground potential, by inserting an electrical insulating section to avoid an electrical short circuit. Such kind of heat pipes are usually gravity driven and called thermosyphons.

The insulation section mentioned above as part of the cooling system needs to be gastight as well as to keep the cooling fluid inside the cooling system. In some cases, also additional bushings might be needed to guide the cooling system through the sidewall of the panel or wall of the switchgear.

Overall, such cooling systems can be complicated and expensive.

There is a need to provide a better cooling solution for high voltage systems such as medium voltage switchgear, and control gear and other switching systems.

### SUMMARY OF THE INVENTION

Therefore, it would be advantageous to have an improved cooling mechanism for a medium voltage switchgear.

The object of the present invention is solved with the subject matter of the independent claims, wherein further embodiments are incorporated in the dependent claims.

In a first aspect, there is provided a cooling system for a medium voltage switchgear. The cooling system comprises:
- a conductor;
- a fluid conduit; and
- an insulator.
The conductor extends in a longitudinal axis. The conductor is configured to carry electrical current in the longitudinal axis direction. A first part of the fluid conduit is located around an outer surface of the conductor and extends around the longitudinal axis. A second part of the fluid conduit is connected to the first part of the fluid conduit and extends substantially perpendicularly to the longitudinal axis. The insulator is located around the conductor at the position of the fluid conduit and covers the first part of the fluid conduit. The cooling system is configured such that a fluid can flow into the second part of the fluid conduit and from the second part of the fluid conduit into the first part of the fluid conduit.

In an example, an inner surface of the insulator is adjacent to and spaced from the outer surface of the conductor and forms an outer surface of the first part of the fluid conduit.

In other words, the fluid conduit is formed by a hollow channel in the insulator that has channel walls formed by the insulator and the conductor.

Thus, there is no channel material or conduit material of the fluid conduit as such, with the fluid conduit formed from the space between the insulator and the conductor.

In an example, an outer surface of the fluid conduit comprises a polymer material. A first section of the polymer material of the first part of the fluid conduit is in contact with the outer surface of the conductor.

In an example, a second section of the polymer material of the first part of the fluid conduit is in contact with an inner surface of the insulator that is adjacent to and spaced from the outer surface of the conductor.

Thus, the fluid conduit is formed from material other than the insulator and the conductor, rather now an actual channel or tube of a polymer material forms the fluid conduit.

In an example, the outer surface of the conductor at the position where the first part of the fluid conduit is located has a perimeter of a first length and wherein the outer surface of the conductor at a position adjacent to which the first part of the fluid conduit is located has a perimeter of a second length, and wherein the first length is greater than the second length.

To put this another way, for example a conductor of a circular cross-section the fluid conduit of the cooling system is located at a part of the conductor that has an increased diameter over that an adjacent part of the conductor. In other words, this could be considered to be located at a chamfer of the conductor. Thus, the fluid conduit could for example be slid along the conductor over the chamfer to the wider section of the conductor, thereby providing a really tight fit around the conductor and consequently effective and efficient thermal conduction between the fluid flowing through the fluid conduit and the conductor, thereby effectively extracting heat from the conductor.

In an example, the outer surface of the conductor at the position of the first part of the fluid conduit has a notch.

Thus, the fluid conduit can be securely positioned at this location of the conductor, for example, by for example sliding it along the conductor until it "clicks" into the notch.

In an example, the cooling structure comprises a cap nut located around the conductor adjacent to the first part of the fluid conduit.

In this manner, a simple mechanism is provided of keeping the cooling system in place.

In an example, the insulator is cast around the conductor.

In a second aspect, there is provided a cooling structure for a medium voltage switchgear, the cooling structure comprising:
- a fluid conduit; and
- an insulator
A first part of the fluid conduit is configured to be located around an outer surface of a conductor and extend around a longitudinal axis of the conductor, and wherein the conductor is configured to carry electrical current in the longitudinal axis direction. A second part of the fluid conduit is connected to the first part of the fluid conduit and is configured to extend substantially perpendicularly to the longitudinal axis of the conductor. The insulator is configured to be located around the conductor at the position of the fluid conduit and cover the first part of the fluid conduit. The cooling structure is configured such that a fluid can flow into the second part of the fluid conduit and from the second part of the fluid conduit into the first part of the fluid conduit.

Thus in effect, such a cooling structure can be retrofitted to an existing switchgear.

In a third aspect, there is provided a method of manufacturing a cooling system for a medium voltage switchgear. The cooling system comprises a conductor, a fluid conduit, and an insulator. The conductor extends in a longitudinal axis, and the conductor is configured to carry electrical current in the longitudinal axis direction. The method comprises:
- locating a first part of the fluid conduit around an outer surface of the conductor that extends around the longitudinal axis;
- locating a second part of the fluid conduit that is connected to the first part of the fluid conduit and that extends substantially perpendicularly to the longitudinal axis; and
- locating the insulator around the conductor at the position of the fluid conduit and that covers the first part of the fluid conduit.
   The cooling system is configured such that a fluid can flow into the second part of the fluid conduit and from the second part of the fluid conduit into the first part of the fluid conduit.

In an example, locating the insulator around the conductor at the position of the fluid conduit comprises casting the insulator around the conductor.

In an example, the method comprises:
- locating a soluble structure around the outer surface of the conductor that also extends substantially perpendicularly to the longitudinal axis of the conductor, and then
- locating the insulator around the conductor, and then
- removing the soluble structure to form the first part of the fluid conduit and the second part of the fluid conduit.

In an example, the method comprises:
- locating a polymer material channel around the outer surface of the conductor and that also extends substantially perpendicularly to the longitudinal axis of the conductor, and then
- locating the insulator around the conductor.
The polymer material channel forms the first part of the fluid conduit and the second part of the fluid conduit.

In an example, locating the polymer material channel around the outer surface of the conductor and that also extends substantially perpendicularly to the longitudinal axis of the conductor comprises:
- sliding the polymer material channel along the longitudinal axis over a chamfer to the position where the first part of the fluid conduit is located, and where the outer surface of the conductor has a perimeter past the chamfer that is greater than the perimeter prior to the chamfer.

In an example, locating the polymer material channel around the outer surface of the conductor and that also extends substantially perpendicularly to the longitudinal axis of the conductor comprises:
- sliding the polymer material channel along the longitudinal axis of the conductor to a notch in the outer surface of the conductor at the position of the first part of the fluid conduit.

In a fourth aspect there is provided a medium voltage switchgear comprising a cooling system according to the first aspect, and/or a cooling structure according to the second aspect, and/or a cooling system manufactured according to the method of the third aspect.

The above aspects and examples will become apparent from and be elucidated with reference to the embodiments described hereinafter.

### BRIEF DESCRIPTION OF THE DRAWINGS

Exemplary embodiments will be described in the following with reference to the following drawing:
Fig. 1 shows an example of a side view of a cooling structure surrounding a conductor, with a longitudinal axis of the conductor extending from the left to the right and along which current flows; and
Fig. 2 shows a cross-sectional view of the cooling structure of Fig. 1 at the position of the cooling channel or fluid conduit.

### DETAILED DESCRIPTION OF EMBODIMENTS

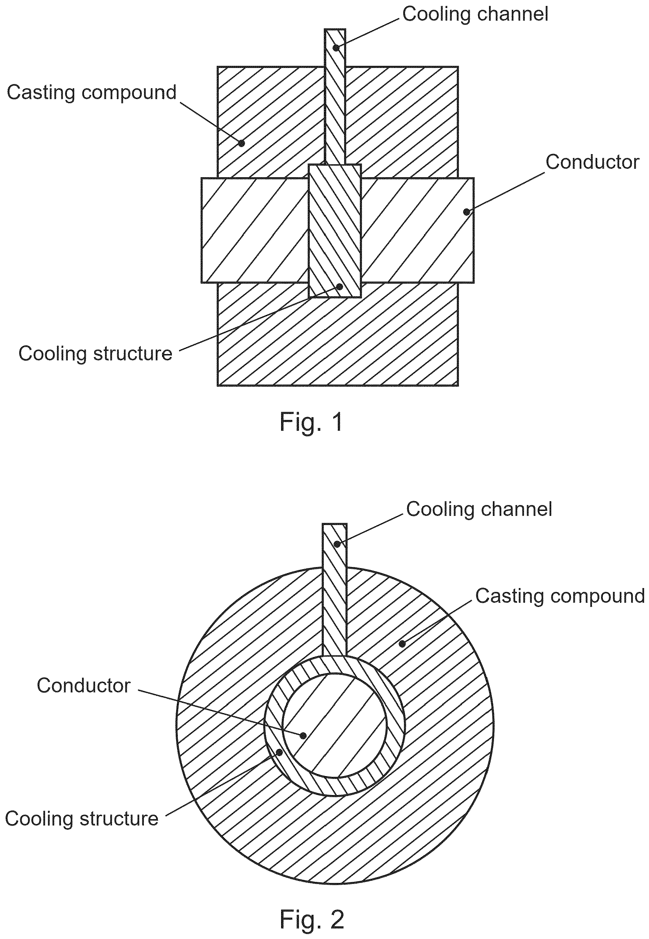

Figs. 1-2 relate to a cooling structure than can be fitted to a conductor of a medium voltage switchgear, the cooling system that includes the conductor, a method of manufacturing cooling system, and to a switchgear comprising such cooling systems that could have been made by the method.

An example of a cooling system for a medium voltage switchgear comprises a conductor, a fluid conduit, and an insulator. The conductor extends in a longitudinal axis. The conductor is configured to carry electrical current in the longitudinal axis direction. A first part of the fluid conduit is located around an outer surface of the conductor and extends around the longitudinal axis. A second part of the fluid conduit is connected to the first part of the fluid conduit and extends substantially perpendicularly to the longitudinal axis. The insulator is located around the conductor at the position of the fluid conduit and covers the first part of the fluid conduit. The cooling system is configured such that a fluid can flow into the second part of the fluid conduit and from the second part of the fluid conduit into the first part of the fluid conduit.

According to an example, an inner surface of the insulator is adjacent to and spaced from the outer surface of the conductor and forms an outer surface of the first part of the fluid conduit.

According to an example, an outer surface of the fluid conduit comprises a polymer material. A first section of the polymer material of the first part of the fluid conduit is in contact with the outer surface of the conductor.

According to an example, a second section of the polymer material of the first part of the fluid conduit is in contact with an inner surface of the insulator that is adjacent to and spaced from the outer surface of the conductor.

According to an example, the outer surface of the conductor at the position where the first part of the fluid conduit is located has a perimeter of a first length. The outer surface of the conductor at a position adjacent to which the first part of the fluid conduit is located has a perimeter of a second length. The first length is greater than the second length.

According to an example, the outer surface of the conductor at the position of the first part of the fluid conduit has a notch.

According to an example, the cooling structure comprises a cap nut located around the conductor adjacent to the first part of the fluid conduit.

In an example, the conductor has a substantially circular cross section at the location of the first part of the fluid conduit.

According to an example, the insulator is cast around the conductor.

An example of a cooling structure for a medium voltage switchgear comprises a fluid conduit, and an insulator. A first part of the fluid conduit is configured to be located around an outer surface of a conductor and extend around a longitudinal axis of the conductor. The conductor is configured to carry electrical current in the longitudinal axis direction. A second part of the fluid conduit is connected to the first part of the fluid conduit and is configured to extend substantially perpendicularly to the longitudinal axis of the conductor. The insulator is configured to be located around the conductor at the position of the fluid conduit and cover the first part of the fluid conduit. The cooling structure is configured such that a fluid can flow into the second part of the fluid conduit and from the second part of the fluid conduit into the first part of the fluid conduit.

In an example, an inner surface of the insulator is configured to be adjacent to and spaced from the outer surface of the conductor and form an outer surface of the first part of the fluid conduit.

In an example, an outer surface of the fluid conduit comprises a polymer material. A first section of the polymer material of the first part of the fluid conduit is configured to be in contact with the outer surface of the conductor.

In an example, a second section of the polymer material of the first part of the fluid conduit is in contact with an inner surface of the insulator that is adjacent to and is configured to be spaced from the outer surface of the conductor.

In an example, the cooling structure comprises a cap nut configured to be located around the conductor adjacent to the first part of the fluid conduit.

In an example, the cooling structure is configured for a conductor that has a substantially circular cross section at the location of the first part of the fluid conduit.

In an example, the insulator is configured to be cast around the conductor.

An example of a method of manufacturing a cooling system for a medium voltage switchgear is now described. When manufactured the cooling system comprises a conductor, a fluid conduit, and an insulator. The conductor extends in a longitudinal axis and the conductor is configured to carry electrical current in the longitudinal axis direction. Continuing with the method, this comprises:
- locating a first part of the fluid conduit around an outer surface of the conductor that extends around the longitudinal axis;
- locating a second part of the fluid conduit that is connected to the first part of the fluid conduit and that extends substantially perpendicularly to the longitudinal axis; and
- locating the insulator around the conductor at the position of the fluid conduit and that covers the first part of the fluid conduit.
When the cooling system is manufactured a fluid can flow into the second part of the fluid conduit and from the second part of the fluid conduit into the first part of the fluid conduit.

According to an example, locating the insulator around the conductor at the position of the fluid conduit comprises casting the insulator around the conductor.

According to an example, the method comprises locating a soluble structure around the outer surface of the conductor that also extends substantially perpendicularly to the longitudinal axis of the conductor, and then locating the insulator around the conductor, and then removing the soluble structure to form the first part of the fluid conduit and the second part of the fluid conduit.

According to an example, the method comprises locating a polymer material channel around the outer surface of the conductor and that also extends substantially perpendicularly to the longitudinal axis of the conductor, and then locating the insulator around the conductor- The polymer material channel forms the first part of the fluid conduit and the second part of the fluid conduit.

According to an example, locating the polymer material channel around the outer surface of the conductor and that also extends substantially perpendicularly to the longitudinal axis of the conductor comprises sliding the polymer material channel along the longitudinal axis over a chamfer to the position where the first part of the fluid conduit is located. The outer surface of the conductor has a perimeter past the chamfer that is greater than the perimeter prior to the chamfer.

According to an example, locating the polymer material channel around the outer surface of the conductor and that also extends substantially perpendicularly to the longitudinal axis of the conductor comprises sliding the polymer material channel along the longitudinal axis of the conductor to a notch in the outer surface of the conductor at the position of the first part of the fluid conduit.

In an example, the conductor has a substantially circular cross section at the location of the first part of the fluid conduit.

A medium voltage switchgear can then have any one, two or three of the above described cooling systems (whether manufactured by the method or not) or structure.

Thus, in a specific embodiment the new cooling technology is to integrate a cooling duct (fluid conduit) inside an insulating compound (insulator). The duct of the cooling structure/system is embedded inside the compound. The hollow channel (fluid conduit) can be provided by a polymer material. Different types of the polymers can be used for fabrication of the channel structure, such as: thermoplastic, elastomers, thermosetting or photo curable materials. The polymer hollow channel is casted in a compound made of a thermosetting material. Such a thermosetting material is able to provide a sufficient tightness regarding insulation gases and the cooling fluid at same time.

The cooling channel structure can either be over molded and dissolved after the casting process or can be embedded and remains inside the compound. In the above-mentioned dissolving process different solvents can be used, for example water or an alkaline solution.

Fabrication of cooling channel structure, both soluble and embedded, can be realized by means of different manufacturing technologies, such as: injection molding, extrusion, additive manufacturing (e.g. stereolithography - SLA, fused filament fabrication - FFF, selective laser sintering - SLS, etc.).

Alternatively, the cooling channel structure can be made by application of the washout structure printed from the sand, or other material grains, which are joined by a soluble binder. In such an approach the printed structure is encapsulated with thermosetting material and after the casting process of the insulator thermosetting compound the channel structure is dissolved and washed out. As a result, the cooling channel is formed inside the casting thermosetting compound.

The cooling channel structure can be moved over a chamfer onto the conductor, thereby becoming expanded (and so more tightly fitted) and clipped to a notch (and so secured in place). Alternatively, the cooling channel structure cab be placed on the conductor and held by a cap nut.

The cooling channel structure is positioned surrounding current conducting parts with a sufficient pressure or tightness on the surface of the conductor to prevent the compound material from flowing between cooling channel structure and conductor during the casting process

In the situation of thermal hot spots the cooling system/structure can be connected and placed near to the compartment sidewall. It is also possible to integrate such cooling structures in already existing bushings made of thermosetting to avoid additional parts and sealings.

The cooling channel structure is also able to work with pumped single-phase cooling fluids such as dielectric liquids, for example oils etc.

While the invention has been illustrated and described in detail in the drawing and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

## Claims

1. A cooling system for a medium voltage switchgear, the cooling system comprising:
- a conductor;
- a fluid conduit; and
- an insulator;
wherein, the conductor extends in a longitudinal axis;
wherein, the conductor is configured to carry electrical current in the longitudinal axis direction;
wherein, a first part of the fluid conduit is located around an outer surface of the conductor and extends around the longitudinal axis;
wherein, a second part of the fluid conduit is connected to the first part of the fluid conduit and extends substantially perpendicularly to the longitudinal axis;
wherein, the insulator is located around the conductor at the position of the fluid conduit and covers the first part of the fluid conduit; and
wherein, the cooling system is configured such that a fluid can flow into the second part of the fluid conduit and from the second part of the fluid conduit into the first part of the fluid conduit.

2. Cooling system according to claim 1, wherein an inner surface of the insulator is adjacent to and spaced from the outer surface of the conductor and forms an outer surface of the first part of the fluid conduit.

3. Cooling system according to claim 1, wherein an outer surface of the fluid conduit comprises a polymer material, and wherein a first section of the polymer material of the first part of the fluid conduit is in contact with the outer surface of the conductor.

4. Cooling system according to claim 3, wherein a second section of the polymer material of the first part of the fluid conduit is in contact with an inner surface of the insulator that is adjacent to and spaced from the outer surface of the conductor.

5. Cooling system according to any of claims 3-4,
wherein the outer surface of the conductor at the position where the first part of the fluid conduit is located has a perimeter of a first length and wherein the outer surface of the conductor at a position adjacent to which the first part of the fluid conduit is located has a perimeter of a second length, and wherein the first length is greater than the second length.

6. Cooling system according to any of claims 3-5,
wherein the outer surface of the conductor at the position of the first part of the fluid conduit has a notch.

7. Cooling system according to any of claims 3-6,
wherein the cooling structure comprises a cap nut located around the conductor adjacent to the first part of the fluid conduit.

8. Cooling system according to any of claims 1-7,
wherein the insulator is cast around the conductor.

9. A cooling structure for a medium voltage switchgear, the cooling structure comprising:
- a fluid conduit; and
- an insulator;
wherein, a first part of the fluid conduit is configured to be located around an outer surface of a conductor and extend around a longitudinal axis of the conductor, and wherein the conductor is configured to carry electrical current in the longitudinal axis direction;
wherein, a second part of the fluid conduit is connected to the first part of the fluid conduit and is configured to extend substantially perpendicularly to the longitudinal axis of the conductor;
wherein, the insulator is configured to be located around the conductor at the position of the fluid conduit and cover the first part of the fluid conduit; and
wherein, the cooling structure is configured such that a fluid can flow into the second part of the fluid conduit and from the second part of the fluid conduit into the first part of the fluid conduit.

10. A method of manufacturing a cooling system for a medium voltage switchgear, the cooling system comprising a conductor, a fluid conduit, and an insulator, wherein the conductor extends in a longitudinal axis; wherein the conductor is configured to carry electrical current in the longitudinal axis direction; and wherein the method comprises:
- locating a first part of the fluid conduit around an outer surface of the conductor that extends around the longitudinal axis;
- locating a second part of the fluid conduit that is connected to the first part of the fluid conduit and that extends substantially perpendicularly to the longitudinal axis; and
- locating the insulator around the conductor at the position of the fluid conduit and that covers the first part of the fluid conduit; and
wherein the cooling system is configured such that a fluid can flow into the second part of the fluid conduit and from the second part of the fluid conduit into the first part of the fluid conduit.

11. Method according to claim 9, wherein locating the insulator around the conductor at the position of the fluid conduit comprises casting the insulator around the conductor.

12. Method according to any of claims 9-10, wherein the method comprises locating a soluble structure around the outer surface of the conductor that also extends substantially perpendicularly to the longitudinal axis of the conductor, and then locating the insulator around the conductor, and then removing the soluble structure to form the first part of the fluid conduit and the second part of the fluid conduit.

13. Method according to any of claims 9-10, wherein the method comprises locating a polymer material channel around the outer surface of the conductor and that also extends substantially perpendicularly to the longitudinal axis of the conductor, and then locating the insulator around the conductor, and wherein the polymer material channel forms the first part of the fluid conduit and the second part of the fluid conduit.

14. Method according to claim 12, wherein locating the polymer material channel around the outer surface of the conductor and that also extends substantially perpendicularly to the longitudinal axis of the conductor comprises sliding the polymer material channel along the longitudinal axis over a chamfer to the position where the first part of the fluid conduit is located wherein the outer surface of the conductor has a perimeter past the chamfer that is greater than the perimeter prior to the chamfer.

15. Method according to any of claims 12-13, wherein locating the polymer material channel around the outer surface of the conductor and that also extends substantially perpendicularly to the longitudinal axis of the conductor comprises sliding the polymer material channel along the longitudinal axis of the conductor to a notch in the outer surface of the conductor at the position of the first part of the fluid conduit.

16. A medium voltage switchgear comprising a cooling system according to any of claims 1-8, and/or a cooling structure according to claim 9, and/or a cooling system manufactured according to the method of any of claims 10-15.
